# EUROPÄISCHE PATENTSCHRIFT

(11) **EP 1 179 287 B1**
(45) Veröffentlichungstag und Bekanntmachung des Hinweises auf die Patenterteilung: **27.10.2004**
(21) Anmeldenummer: 00927028.1
(22) Anmeldetag: 22.04.2000
(51) Int. Cl.: H05B 6/00

(54) **VORRICHTUNG UND VERFAHREN ZUM THERMISCHEN BEHANDELN VON SUBSTRATEN**
DEVICE AND METHOD FOR THERMALLY TREATING SUBSTRATES
DISPOSITIF ET PROCEDE DE TRAITEMENT THERMIQUE DE SUBSTRATS

(30) Priorität: 21.05.1999 DE 19923400
(43) Veröffentlichungstag der Anmeldung: 13.02.2002
(73) Patentinhaber: STEAG RTP Systems GmbH, 89160 Dornstadt (DE)
(72) Erfinder: WALK, Heinrich, D-89604 Allmendingen (DE); MADER, Roland, D-87439 Kempten (DE); BLERSCH, Werner, D-88477 Bussmannshausen (DE); HAUF, Markus, D-89335 Ichenhausen (DE)
(74) Vertreter: Geyer, Ulrich F., Dr. Dipl.-Phys.
(86) Internationale Anmeldenummer: PCT/EP2000/003665
(87) Internationale Veröffentlichungsnummer: WO 2000/072636

(56) Entgegenhaltungen:
- EP-A- 0 468 874
- WO-A-00/14775
- PATENT ABSTRACTS OF JAPAN vol. 1999, no. 04, 30. April 1999 (1999-04-30) & JP 11 008204 A (SCI TECHNOL KK), 12. Januar 1999 (1999-01-12)
- PATENT ABSTRACTS OF JAPAN vol. 1999, no. 04, 30. April 1999 (1999-04-30) & JP 11 003868 A (NEC YAMAGATA LTD), 6. Januar 1999 (1999-01-06)

## Beschreibung

Die vorliegende Erfindung bezieht sich auf eine Vorrichtung und ein Verfahren zum thermischen Behandeln von Substraten, insbesondere Halbleiterwafern, mit wenigstens einer Heizvorrichtung zum Erwärmen wenigstens eines Substrats durch elektromagnetische Strahlung, wobei die Heizvorrichtung wenigstens zwei Bogenlampen umfaßt.

Eine Vorrichtung der oben genannten Art ist beispielsweise aus der US-A-4,698,486 bekannt, bei der ein in einer Reaktionskammer befindlicher Halbleiterwafer zunächst über ein Anordnung von Quarz-Halogenlampen erwärmt wird. Beim Erreichen einer bestimmten Temperatur der Wafer wird eine zusätzliche Lampenanordnung, nämlich eine Hochleistungs-Blitzlampenanordnung, für die Erwärmung der Wafer eingesetzt. Die Blitzlampenanordnung wird nur für eine kurze Zeitdauer eingesetzt, wobei dabei die Oberflächentemperatur des Wafers auf eine Temperatur in der Nähe des Schmelzpunktes des Halbleitermaterials angehoben wird. Aufgrund der kurzen Einsatzzeit der Blitzlampen wird die Temperatur des Wafers nur im Bereich der Waferoberfläche durch die Blitzlampen beeinflußt, was zu einer inhomogenen Temperaturverteilung über die Höhe des Wafers hinweg führt. Die Quarz-Halogenlampen als auch die Blitzlampen sind in einer die Reaktionskammer umgebenden, hochreflektierenden Kammer angeordnet, die in der Form eines Kaleidoskops aufgebaut ist. Um eine homogene Temperaturverteilung auf der Oberfläche des Wafers in der Reaktionskammer zu erreichen, ist bei dieser bekannten Vorrichtung wichtig, daß der Abstand zwischen den jeweiligen Lampen und der Oberfläche des Wafers größer oder zumindest gleich dem Durchmesser der reflektierenden Kammer ist. Dieser Abstand zwischen den jeweiligen Lampen und der Waferoberfläche führt insbesondere bei einer Vorrichtung, die zur beidseitigen Erwärmung des Wafers geeignet ist, zu einer großen Baugröße der Vorrichtung. Bei immer größer werdenden Waferdurchmessern, wie beispielsweise 300 mm-Wafern, ist somit eine sehr große, reflektierende Kammer erforderlich, was zu hohen Herstellungs- und Unterhaltungskosten der Vorrichtung führt.

Aus der US-A-4,398,094 sowie der US-A-5,336,641 sind jeweils Vorrichtungen zum thermischen Behandeln von Halbleiterwafern bekannt, bei denen als Wärmequelle jeweils eine einzelne Bogenlampe mit einem Spiegel verwendet wird. Die als Wärmequelle verwendeten Bogenlampen sind dabei in der Regel Hochleistungs-Bogenlampen, mit einem aufwendigen Aufbau und einer aufwendigen Kühlvorrichtung. Aufgrund der Verwendung einer einzelnen Lampe ist eine homogene thermische Behandlung des Wafers nicht zu erreichen.

Aus der DD-A-295950 ist es ferner bekannt, UV-Strahler mit unterschiedlichen Konfigurationen in Kombination mit Glühlampen für die thermische Behandlung von Halbleiterwafern zu verwenden. Dabei wird eine Metalldampf-Niederdruck-UV-Quelle verwendet, die nur unwesentlich zur gesamten Strahlungsleistung der Heizvorrichtung beiträgt. Aufgabe des UV-Strahlers ist nicht die eigentliche Erwarmung des Wafers, sondern die Förderung photochemischer Reaktionen in Verbindung mit thermisch aktivierten Prozessen durch die UV-Bestrahlung.

Die meisten derzeitig im Handel erhältlichen Vorrichtungen zum thermischen Behandeln von Substraten verwenden ausschließlich Glühlampen für die thermische Behandlung von Halbleiterwafern. Diese besitzen jedoch den Nachteil, daß die Strahlung der Glühlampen bei Wafertemperaturen unter 600°C nur sehr gering absorbiert wird. Dies liegt an dem charakteristischen Spektrum der Glühlampen, welches bei Wellenlängen von circa 1000 nm sein Maximum aufweist. Der Absorptionsgrad eines Si-Halbleitersubstrats ist jedoch für Wellenlängen in diesem Bereich stark temperaturabhängig und variiert von etwa 0,1 bis 0,7. Erst bei Temperaturen von mehr als 600°C ist der Absorptionsgrad in diesem Wellenlängenbereich nahezu wellenlängenunabhängig. Dies hat zur Folge, daß die Energie der Glühlampen erst ab einer Wafertemperatur von ca. 600°C effektiv absorbiert wird.

Aus der JP-11008204 A sowie der JP-11003868 A sind jeweils Vorrichtungen zum thermischen Behandeln von Halbleiterwafern mit einer Vielzahl von individuell ansteuerbaren Glühlampen desselben Typs gezeigt.

Ausgehend von den bekannten Vorrichtungen liegt der vorliegenden Erfindung die Aufgabe zugrunde, eine Vorrichtung der Eingangs genannten Art zu schaffen, die eine effektive, kostengünstige und homogene thermische Behandlung von Substraten ermöglicht.

Erfindungsgemäß wird diese Aufgabe durch eine Vorrichtung gemäß Anspruch 1 bzw. ein Verfahren gemäß Anspruch 32 gelöst. Insbesondere sind bei einer Vorrichtung die Abstrahlcharakteristika für jede Bogenlampe durch eine Steuervorrichtung individuell steuerbar sind wobei die elektromagnetische Strahlung der Bogenlampen wenigstens 1/10 zur Leistungsdichte der Heizvorrichtung beitragen. Die Verwendung von Bogenlampen, welche wesentlich zur Leistungsdichte der elektromagnetischen Strahlung der Heizvorrichtung beitragen, besitzt den Vorteil, daß diese in einem Spektralbereich strahlen, in dem beispielsweise Si-Wafer die höchste Absorption aufweisen, und zwar schon bei Raumtemperatur. Somit ist durch die Bogenlampen in Kombination mit den Glühlampen eine effektive Erwärmung insbesondere von Halbleiterwafern auch bei Raumtemperaturen möglich. Durch die Möglichkeit einer individuellen Ansteuerung der Bogenlampen ist das räumliche Strahlungsfeld der Lampen einstellbar, was eine homogene Strahlungsverteilung und somit eine homogene Temperaturverteilung auf der Waferoberfläche bei geringem Abstand zwischen Bogenlampen und Wafer ermöglicht. Aufgrund der Einstellbarkeit des räumlichen Strahlungsfeldes kann die Heizvorrichtung einschließlich der Bogenlampen in der Nähe der zu behandelnden Substrate angeordnet werden, und es ist nicht notwendig, einen bestimmten, durch den Durchmesser der Behandlungsvorrichtung vorgegebenen Abstand zwischen Heizvorrichtung und Substrat einzuhalten, um eine homogene Substratbehandlung durchführen zu können. Hierdurch kann die Baugröße der Vorrichtung und die damit verbundenen Kosten erheblich reduziert werden.

Vorteilhafterweise ist für eine optimale Anpassung der Abstrahlcharakteristika der Vorrichtung an die Prozeßverhältnisse, insbesondere an das zu behandelnde Substrat, der Betriebsmodus und/oder der Lampenstrom der Bogenlampen individuell steuerbar. Vorteilhafterweise sind die Bogenlampen im Gleichstrombetrieb und/oder gepulst als Blitzlampen ansteuerbar. Für eine gute, effektive Kühlung der Bogenlampen sind diese vorzugsweise fluidgekühlt. Durch eine gute Kühlung der Bogenlampen kann deren Lebenszeit erheblich verlängert werden.

Um eine gute, homogene Temperaturverteilung auf dem zu behandelnden Substrat zu erreichen, entspricht die Gasentladungsstrecke der Bogenlampe im wesentlichen einer Abmessung des Substrats, wie z.B. der Kantenlänge oder dem Durchmesser des Substrats. Sie ist vorzugsweise länger als die Abmessung des Substrats. Vorzugsweise sind die Bogenlampen im Bereich des Außenumfangs des Substrats angeordnet, um die Temperaturverteilung, insbesondere in diesem Bereich, gut steuern zu können. Bogenlampen eignen sich in diesem Bereich besonders gut, da sie ein rasches Ansprechverhalten besitzen.

Vorzugsweise weist die Heizvorrichtung eine Lampenbank mit wenigstens zwei nahezu parallel zueinander angeordneten, stabförmigen Lampen auf. Bei einer Ausführungsform der Erfindung besitzen die Glühlampen und die Bogenlampen im wesentlichen die gleichen Abmessungen, so daß sie gegeneinander ausgetauscht werden können, um die Strahlungscharakteristika innerhalb der Vorrichtung auf das jeweilige Substrat bzw. den jeweiligen thermischen Vorgang speziell abstimmen zu können. Vorteilhafterweise weisen die Glühlampen und die Bogenlampen im wesentlichen die gleiche Lampenleistung auf, so daß das selbe Kühlsystem für die Lampen verwendet werden kann. Für eine erhöhte Effektivität der Vorrichtung ist die Heizvorrichtung von einer wenigstens abschnittsweise die elektromagnetische Strahlung reflektierenden Kammer umgeben, damit nicht direkt auf das Substrat gerichtete Strahlung der Lampen auf das Substrat reflektiert wird. Dabei ist der spektrale Reflexionskoeffizient der Kammer vorzugsweise positionsabhängig, um eine bestimmte spektrale Strahlungsverteilung auf der Substratoberfläche zu erreichen. Insbesondere kann verhindert werden, daß die UV-Strahlung der Bogenlampen auf bestimmte Bereiche des Substrats, die nicht zu den Bogenlampen weisen, reflektiert wird.

Um die Baugröße der Vorrichtung zu reduzieren, ist der Abstand der Heizvorrichtung zu einer Oberfläche des Substrats kleiner als der Durchmesser einer Reaktionskammer. Dabei ist das Verhältnis zwischen Abstand und Durchmesser vorteilhafterweise kleiner als 0,5.

Gemäß einer besonders bevorzugten Ausführungsform der Erfindung sind die Abstrahlcharakteristika der elektromagnetischen Strahlung der Heizvorrichtung modulierbar, wodurch sich eine gute Möglichkeit der Temperaturbestimmung des Wafers ergibt. Dabei ist es ein Vorteil der Bogenlampen, daß diese mit wesentlich höheren Modelationsfrequenzen betrieben werden können als Halogenlampen. Dadurch läßt sich die Temperatur des Objekts insbesondere während der Temperaturänderungen präziser und mit einer einfach ausgestatteten Auswertelektronik bestimmen.

Vorteilhafter Weise befindet sich die Heizvorrichtung und/oder das Substrat in einem nahezu homogenen, einstellbaren Magnetfeld, dessen Feldlinien wenigstens in der Nähe der Bogenlampenanode eine Komponente aufweisen, die im wesentlichen parallel zu der Bogenentladung der Bogenlampen verläuft. Durch das Magnetfeld kann eine Modulation der Lampen erfolgen. Ferner kann durch das Magnetfeld wesentlich auf die Lebensdauer der Bogenlampen Einfluß genommen werden, da sich die Erosionsrate der Anode positiv verringern läßt. Dabei liegt die magnetische Flußdichte des Magnetfelds vorteilhafterweise zwischen 0,005 und 0,3 Tesla.

Für eine beidseitige thermische Behandlung des Substrats weist die Vorrichtung vorzugsweise eine zweite Heizvorrichtung auf, wobei das Substrat zwischen den Heizvorrichtungen angeordnet ist.

Vorteilhafter Weise weist die Vorrichtung eine das Substrat im wesentlichen umgebende, für die elektromagnetische Strahlung der Heizvorrichtung nahezu transparente Reaktionskammer auf, die vorteilhafterweise Quarzglas und/oder Saphir aufweist. Vorteilhafterweise weist das Reaktionskammermaterial einen über das Spektrum der elektromagnetischen Strahlung gemittelten Absorptionskoeffizienten zwischen 0,001 pro Zentimeter und 0,1 pro Zentimeter auf. Die Wanddicke der Reaktionskammer liegt vorzugsweise zwischen einem Millimeter und fünf Zentimeter.

Bei einer bevorzugten Ausführungsform der Erfindung weisen die Glühlampen wenigsten teilweise eine gewendelte Filamentstruktur auf, mit der vorzugsweise ein vordefiniertes geometrisches und spektrales Abstrahlprofil erzielbar ist. Hierfür weist das Filament vorzugsweise abwechselnd gewendelte und ungewendelte Filamentstrukturen auf. Bei einer weiteren, bevorzugten Ausführungsform der Erfindung weist wenigstens eine Glühlampe wenigsten zwei einzeln ansteuerbare Filamente auf. Vorzugsweise weist wenigstens ein Filament einer Glühlampe wenigstens drei elektrische Anschlüsse auf. Vorzugsweise variiert die Dichte wenigstens einer Filamentstruktur entlang des Filaments.

Gemäß einer bevorzugten Ausführungsform der Erfindung bildet die Reaktionskammer und/oder die Lampenkörper einen Frequenzfilter für wenigstens einen Wellenlängenbereich der elektromagnetischen Strahlung der Heizvorrichtung, um innerhalb dieses Spektrums die vom Wafer abgestrahlte Strahlung und damit die Temperatur zu bestimmen, wobei die Lampenstrahlung durch die Filterwirkung unterdrückt wird. Einen solchen Frequenzfilter kann man beispielsweise dadurch erreichen, daß man für die Lampenkolben synthetisches Quarz und für die Reaktionskammer geschmolzenes Quarz wählt. Die Filterwirkung eines derartigen Frequenzfilters kann durch die Wahl der Temperatur des Lampenkörpers zusätzlich beeinflußt werden. Insbesondere wird bei niedrigen Temperaturen die Eigenemission des Lampenkörpers zusätzlich reduziert. Dadurch wird etwa bei 2700 nm die Lampenstrahlung unterdrückt, die Waferstrahlung von 2700 nm kann jedoch durch die Reaktionskammer hindurch erfaßt werden. Allgemein können solche Frequenzfilter als Absorptionsfilter oder in Form von Interferenzfiltern, daß heißt durch Anwendung dünner dielektrischer Schichten, aufgebaut sein. Diese Vorteile lassen sich vorteilhafterweise auch dadurch erreichen, daß wenigstens eine der Lampen zumindest teilweise mit einem Stoff gefüllt ist, der einen bestimmten Wellenlängenbereich der elektromagnetischen Strahlung der Heizvorrichtung absorbiert. Bei den Halogenlampen kann dem Halogengas der Lampenfüllung beispielsweise ein geeigneter Zusatzstoff beigemischt werden, der schmalbandig absorbiert und vorteilhafter Weise im Absorptionsband wenig oder gar nicht emittiert.

Bei dem Verfahren der Eingangs genannten Art werden die Abstrahlcharakteristika für jede Bogenlampe individuell gesteuert, und die elektromagnetische Strahlung der Bogenlampen wird auch so gesteuert, dass sie wesentlich zur Leistungsdichte der elektromagnetischen Strahlung der Heizvorrichtung beiträgt. Hierbei ergeben sich die schon oben genannten Vorteile.

Bei einer besonders bevorzugten Ausführungsform der Erfindung wird das Substrat in einem unteren Temperaturbereich hauptsächlich über die Bogenlampen erwärmt, da Bogenlampen Strahlung in einem Spektralbereich abgeben, die beispielsweise von Si-Halbleiterwafern bei Temperaturen unter 600 °C besser absorbiert wird als die Strahlung von Glühlampen. Vorzugsweise wird das Substrat in einem unteren Temperaturbereich ausschließlich über Bogenlampen erwärmt. Für Si-Halbleiterwafer liegt der untere Temperaturbereich vorzugsweise zwischen Raumtemperatur und ungefähr 600 °C.

Vorzugsweise wird die elektromagnetische Strahlung der Heizvorrichtung moduliert, was gemäß einem Ausführungsbeispiel der Erfindung durch Anlegen eines Magnetfeldes im Bereich des Substrats und/oder der Heizvorrichtung erfolgt, dessen Feldlinie wenigsten im Bereich der Bogenlampenanode eine Komponente aufweisen, die im wesentlichen parallel zur Bogenentladung verläuft.

Die Erfindung wird nachfolgend anhand eines bevorzugten Ausführungsbeispiels unter Bezugnahme auf die Zeichnungen näher erläutert; in den Zeichnungen zeigt:
- Fig. 1: eine schematische Schnittansicht einer Vorrichtung zum thermischen Behandeln von Substraten;
- Fig. 2: eine schematische Schnittansicht eines alternativen Ausführungsbeispiels entlang der Linie A-A in Fig. 3;
- Fig. 3: eine schematische Schnittansicht des Ausführungsbeispiels gemäß Fig. 2 entlang der Linie B-B in Fig. 2.

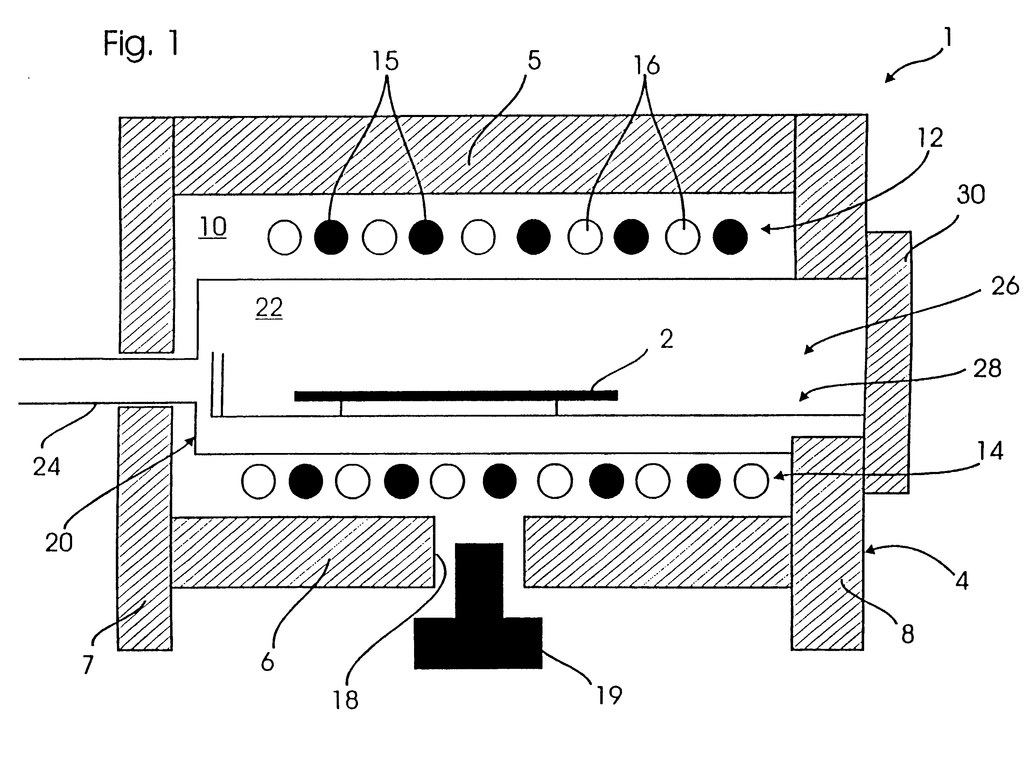

Figur 1 zeigt eine Vorrichtung 1 zum thermischen Behandeln von Halbleiterwafern 2. Die Vorrichtung 1 besitzt ein Gehäuse 4 mit einer oberen Wand 5, einer unteren Wand 6, einer linken Seitenwand 7, einer rechten Seitenwand 8 sowie nicht dargestellten Vorder- und Rückwänden, zur Bildung einer im wesentlichen geschlossenen Kammer 10. Die zur Kammer 10 weisenden Oberflächen der Wände des Gehäuses 4 sind in bekannter Art und Weise beschichtet, um als Spiegelflächen zu dienen, oder die Wände sind aus einem Material, welches eine hohe Reflektivität besitzt.

Innerhalb der Kammer 10 ist benachbart zu der oberen Wand 5 eine erste Lampenanordnung 12 und benachbart zu der unteren Wand 6 eine zweite Lampenanordnung 14 vorgesehen. Die Lampenanordnung 12 besteht aus fünf Bogenlampen 15 sowie fünf Halogenlampen 16, wobei die Vorrichtung natürlich eine unterschiedliche Anzahl von Lampen aufweisen kann. Die Lampen 15 und 16 sind als Stablampen ausgebildet, welche sich im wesentlichen parallel zu der oberen Wand 5 und senkrecht zu der Zeichnungsebene erstrecken. Die Lampen 15 und 16 werden in geeigneter Weise in der nicht dargestellten Vorderwand und der nicht dargestellten Rückwand gehalten. Die Abmessungen der Bogenlampen 15 entsprechen im wesentlichen den Abmessungen der Halogenlampen 16, und sie sind daher gegeneinander austauschbar.

Die Gasentladungsstrecke der Bogenlampen 15 entspricht dem Durchmesser des Wafers 2, um eine gleichmäßige Strahlungsverteilung auf der zu erwärmenden Oberfläche des Wafers zu erreichen.

Die Lampen 15 und 16 der oberen Lampenanordnung 12 sind jeweils einzeln über eine nicht näher dargestellte Steuervorrichtung ansteuerbar. Dabei können die Bogenlampen 15 beispielsweise mit Gleichstrom angesteuert werden, oder sie können gepulst angesteuert werden, so daß sie im Blitzbetrieb arbeiten. Insbesondere ist auch der Lampenstrom und somit die Intensität der abgegebenen Strahlung für jede Lampe individuell ansteuerbar. Durch diese individuelle Ansteuerbarkeit läßt sich sowohl das räumliche als auch das spektrale Strahlungsprofil innerhalb der Kammer 10 genau einstellen. Dabei läßt sich über die Waferoberfläche hinweg eine Homogenität der Temperaturverteilung von besser als 0,5% bei einem 300 mm Wafer und einer Temperatur von 1000 °C erreichen. Insbesondere läßt sich auch die Stromdichte der Bogenlampen steuern, wobei der UV-Anteil der Strahlung bei großen Stromdichten stark zunimmt, sodaß die Bogenlampen einem Strahler mit einer Temperatur zwischen 8000 und 9000 °C entsprechen. Dabei besitzt das Emissionsspektrum der Strahlung ein Maximum bei etwa 350 nm. In diesem Wellenlängenbereich besitzt das Material des Wafers (Si) einen hohen Absorptionskoeffizienten, der im wesentlichen von der Temperatur des Wafers unabhängig ist.

Die untere Lampenbank 14 ist im wesentlichen in der gleichen Art und Weise aus stabförmigen Bogenlampen sowie Halogenlampen aufgebaut und wird daher nicht näher beschrieben. In der unteren Gehäusewand 6 ist eine Öffnung 18 vorgesehen, in die zumindest teilweise ein Pyrometer 19 eingeführt ist, um auf bekannte Art und Weise die Temperatur des Wafers 2 zu ermitteln.

Der Abstand zwischen den oberen und unteren Lampenbänken 12, 14 und dem Wafer liegt in der Regel zwischen 1 cm und 10 cm. Abhängig von dem Durchmesser des zu behandelnden Wafers 2 und somit dem Durchmesser der Kammer 10 ergibt sich ein Verhältnis zwischen dem Abstand und dem Durchmesser welches wesentlich kleiner als 1,0 ist. Vorzugsweise ist das Verhältnis kleiner als 0,5, vorzugsweise sogar kleiner als 0,15. Bei einem Lampenabstand von 1 cm und einem Kammerdurchmesser von 50 cm würde sich beispielsweise ein Verhältnis von 0,02 ergeben.

Die Strahlung der Lampen 15 und 16 wird während des Betriebs der Vorrichtung Moduliert, um in bekannter Art und Weise die Strahlung der Lampen von der vom Wafer emittierten Strahlung unterscheiden zu können. Aus der vom Wafer emittierten Strahlung läßt sich wiederum die Temperatur des Wafers ermitteln. Dabei besitzen die Bogenlampen den Vorteil, daß sie mit einer höheren Modulationsfrequenz betrieben werden können als Halogenlampen. Dadurch läßt sich die Temperatur des Wafers, insbesondere während einer Aufheizphase mit zum Teil raschen Temperaturveränderungen, genauer und mit einer einfacheren Auswerteelektronik bestimmen. Die Modulation kann dabei durch Modulation des Lampenstroms oder bei den Bogenlampen durch Anlegen eines Magnetfeldes, wie nachfolgend noch näher beschrieben wird, erfolgen.

Innerhalb der Kammer 10 ist zwischen den oberen und unteren Lampenanordnungen 12, 14 ein Reaktionskammergehäuse 20 zur Bildung einer Reaktionskammer 22 vorgesehen in der der Wafer in bekannter Art und Weise aufgenommen und gehalten wird. Das Reaktionskammergehäuse besteht aus einem für die elektromagnetische Strahlung der Lampen nahezu transparenten Material, wie beispielsweise Quarzglas und/oder Saphir. Das Reaktionskammergehäuse 20 weist auf seiner linken Seite gemäß Figur 1 eine Einlaßleitung 24 auf, welche sich durch die linke Seitenwand 7 des Gehäuses 4 hindurch erstreckt und mit einer nicht näher dargestellten Gasversorgung in Verbindung steht. Über die Einlaßleitung 24 wird während der thermischen Behandlung des Wafers 2 ein Gas in die Reaktionskammer 22 eingeleitet, um bestimmte Prozeßparameter vorzusehen.

Auf der rechten Seite besitzt das Reaktionskammergehäuse 20 eine Öffnung 26, die mit einer Öffnung 28 in der rechten Seitenwand 8 des Gehäuses 4 in Verbindung steht. Die Öffnung 28 ist durch eine Tür 30 verschlossen, die zum Einsetzen und Herausnehmen des Wafers 2 aus der Reaktionskammer 22 geöffnet werden kann.

Bei dem in Figur 1 dargestellten Ausführungsbeispiel der Erfindung weist sowohl die obere Lampenanordnung 12 als auch die untere Lampenanordnung 14 Bogenlampen und Halogenlampen auf. Bei der Behandlung von strukturierten Wafern kann es zur Schonung der Strukturen jedoch vorteilhaft sein, daß kein UV-Licht auf die Strukturen fällt. Um dies zu verhindern, weist bei einer alternativen, nicht dargestellten Ausführungsform der Erfindung beispielsweise die obere Lampenbank 12, zu der die Strukturen des Wafers weisen, keine Bogenlampen auf. Darüber hinaus sind die oberhalb einer Ebene des Wafers liegenden Innenwände der Kammer 10 mit einem Material, wie beispielsweise Gold, beschichtet, welches für UV-Licht einen sehr kleinen Reflexionskoeffizienten aufweist. Somit wird verhindert, daß UV-Licht direkt auf die Strukturen des Wafers 2 fällt oder auf dieses reflektiert wird. Die unterhalb einer Ebene des Wafers 2 liegenden Innenwände der Kammer 10 können hingegen mit einem UV-Licht reflektierenden Material, wie beispielsweise Aluminium, beschichtet sein, um eine effiziente Bestrahlung und somit Erwärmung der Unterseite des Wafers auch mit UV-Strahlung zu erreichen.

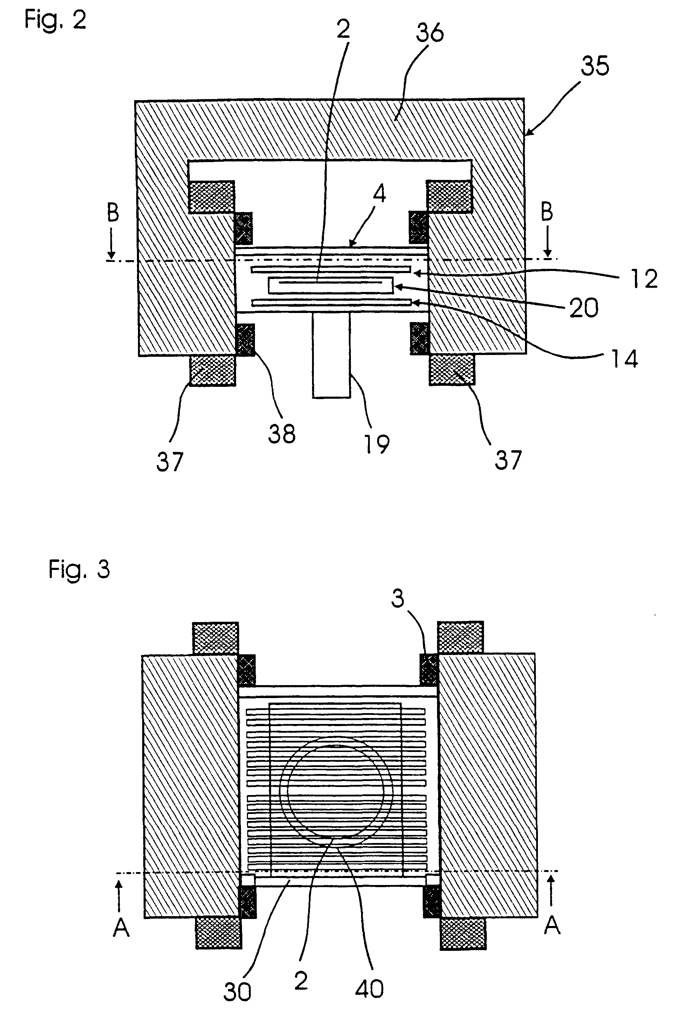

Figur 2 zeigt eine alternative Ausführungsform einer thermischen Behandlungsvorrichtung für Substrate, wobei in Figur 2 die gleichen Bezugszeichen wie in Figur 1 verwendet werden, um gleiche oder äquivalente Bauteile zu bezeichnen.

So weist die Vorrichtung gemäß Figur 2 im wesentlichen in gleicher Weise wie die Vorrichtung gemäß Figur 1 ein Gehäuse 4 mit einem darin angeordneten Reaktionskammergehäuse 20 sowie Lampenanordnungen 12 und 14 auf.

Wie zu erkennen ist, erstreckt sich der Schnitt gemäß Figur 2 parallel zu den Lampenanordnungen 12 und 14. Das Gehäuse 4 ist teilweise von einem Elektromagneten 35 umgeben. Der Elektromagnet 35 weist ein ferromagnetisches Joch 36 sowie Spulen 37 zum Anlegen eines Magnetfeldes auf. Das Joch 36 und die Spulen 37 sind derart angeordnet, daß sie ein Magnetfeld erzeugen, welches sich im wesentlichen parallel zu den Lampen der Lampenanordnungen 12, 14 bzw. im wesentlichen parallel zur Waferoberfläche erstrecken. Durch Anordnung von Hilfsspulen 38, welche ebenfalls am Elektromagnet 35 vorgesehen sind, läßt sich die Homogenität des Magnetfeldes einstellen. Über das durch den Elektromagneten 35 erzeugte Magnetfeld sind die geometrischen und spektralen Abstrahlcharakteristika der in den Lampenanordnungen 12 und 14 enthaltenen Bogenlampen einstellbar. Ferner kann über das Magnetfeld die Lebensdauer der Bogenlampen verlängert werden. Über eine Modulation des Magnetfeldes kann darüber hinaus die Strahlungsintensität der Bogenlampen moduliert werden, was dem Pyrometer 19 die Ermittlung der Wafertemperatur ermöglicht.

Anstelle oder auch in Verbindung mit der Modulation der Lampenstrahlung besteht auch die Möglichkeit einen Frequenzfilter für wenigstens einen Wellenlängenbereich der elektromagnetischen Strahlung der Lampen vorzusehen. Hierdurch ergibt sich eine alternative, wenigstens in einem Frequenzbereich gegebene Unterscheidung zwischen der vom Wafer emittierten Strahlung und der von den Lampen emittierten Strahlung. Diese ermöglicht wiederum eine Temperaturbestimmung des Wafers. Dabei könnte beispielsweise der Lampenkörper und/oder die Reaktionskammer einen Frequenzfilter bilden. Die Filterwirkung läßt sich beispielsweise dadurch erreichen, daß man für den Lampenkörper synthetisches Quarz und für die Reaktionskammer geschmolzenes Quarz verwendet. Das synthetische Quarz unterdrückt bei etwa 2700 nm die Lampenstrahlung, während das geschmolzene Quarz die vom Wafer in diesem Wellenlängenbereich emittierte Strahlung hindurchläßt, so daß die Strahlung in diesem Wellenlängenbereich pyrometrisch erfaßt und für die Temperaturbestimmung des Wafers verwendet werden kann. Solche Frequenzfilter können als Absorptionsfilter oder in der Form von Interferenzfiltern, d.h. durch vorsehen dünner dielektrischer Schichten erzeugt werden.

Ferner besteht, insbesondere bei Halogenlampen, die Möglichkeit, dem Gas der Lampenfüllung einen geeigneten Zusatzstoff beizumischen, der schmalbandig absorbiert und im Absorptionsband wenig oder gar nicht emittiert.

Figur 3 zeigt eine Schnittansicht der Vorrichtung gemäß Figur 2 entlang der Linie B-B, wobei in dieser Ansicht ein den Wafer 2 umgebender Kompensationsring 40 zu erkennen ist.

Obwohl die Vorrichtung anhand bevorzugter Ausführungsbeispiele beschrieben wurde, sei bemerkt, daß die Erfindung nicht auf diese beschränkt ist. Insbesondere ist beispielsweise eine Vorrichtung möglich, die ausschließlich einzeln ansteuerbare Bogenlampen innerhalb der Lampenanordnungen 12 und 14 aufweist. Natürlich können Bogenlampen auch mit anderen als den beschriebenen Halogenlampen innerhalb der Lampenanordnungen verwendet werden. Ferner ist es auch nicht notwendig, zwei separate Lampenanordnungen 12, 14 vorzusehen, da ggf. auch eine einzelne Lampenanordnung, wie beispielsweise die Lampenanordnung 12, zur thermischen Behandlung des Halbleiterwafers 2 ausreicht. Bestimmte der oben beschriebenen Merkmale, wie z.B. das Vorsehen von Frequenzfiltern beziehungsweise das Beimischen eines schmalbandig absorbierenden Gases zu der Lampenfüllung von Heizlampen sind unabhängig von der Verwendung bestimmter Lampenarten, und insbesondere unabhängig von der Verwendung von Bogenlampen.

## Patentansprüche

1. Vorrichtung (1) zum thermischen Behandeln von Substraten (2), insbesondere Halbleiterwafern, mit einer Reaktionskammer mit wenigstens einer Heizvorrichtung (12; 14) zum Erwärmen wenigstens eines Substrats (2) durch elektromagnetische Strahlung, wobei die Heizvorrichtung (12; 14) wenigstens zwei Bogenlampen (15) sowie Glühlampen (16) umfaßt,
**dadurch gekennzeichnet, daß** die Abstrahlcharakteristika für jede Bogenlampe (15) durch eine Steuervorrichtung individuell steuerbar sind, die elektromagnetischen Strahlung der Bogenlampen (15) wesentlich zur Leistungsdichte der elektromagnetischen Strahlung der Heizvorrichtung (12; 14) beiträgt, wobei die Bogenlampen (15) wenigstens 1/10 zur Leistungsdichte der Heizvorrichtung beitragen, und der Abstand der Heizvorrichtung (12; 14) zu einer Oberfläche des Substrats (2) kleiner ist als der Durchmessers der Reaktionskammer (22), wobei das Verhältnis zwischen Abstand und Durchmesser kleiner als 0.5 ist.

2. Vorrichtung (1) nach Anspruch 1, **dadurch gekennzeichnet, daß** der Betriebsmodus und/oder der Lampenstrom individuell steuerbar ist.

3. Vorrichtung (1) nach Anspruch 1 oder 2, **dadurch gekennzeichnet, daß** die Bogenlampen (15) im Gleichstrombetrieb ansteuerbar sind.

4. Vorrichtung (1) nach einem der Ansprüche 1 bis 3, **dadurch gekennzeichnet, daß** die Bogenlampen (15) gepulst als Blitzlampen ansteuerbar sind.

5. Vorrichtung (1) nach einem der vorhergehenden Ansprüche, **dadurch gekennzeichnet, daß** die Bogenlampen (15) fluidgekühlt sind.

6. Vorrichtung (1) nach einem der vorhergehenden Ansprüche, **dadurch gekennzeichnet, daß** die Gasentladungsstrecke der Bogenlampen (15) im wesentlichen einer Abmessung des Substrats (2) entspricht.

7. Vorrichtung (1) nach einem der vorhergehenden Ansprüche, **dadurch gekennzeichnet, daß** die Gasentladungsstrecke der Bogenlampen (15) länger ist als eine Abmessung des Substrats (2).

8. Vorrichtung (1) nach einem der vorhergehenden Ansprüche, **dadurch gekennzeichnet, daß** die Bogenlampen (15) im Bereich des Außenumfangs des Substrats (2) angeordnet sind.

9. Vorrichtung (1) nach einem der vorhergehenden Ansprüche, **dadurch gekennzeichnet, daß** die Heizvorrichtung eine Lampenbank mit wenigstens zwei nahezu parallel zueinander angeordneten stabförmigen Lampen (15; 16) aufweist.

10. Vorrichtung (1) nach einem der vorhergehenden Ansprüche, **dadurch gekennzeichnet, daß** die Glühlampen (16) und die Bogenlampen (15) im wesentlichen die gleichen Abmessungen aufweisen.

11. Vorrichtung (1) nach einem der vorhergehenden Ansprüche, **dadurch gekennzeichnet, daß** die Glühlampen (16) und die Bogenlampen (15) im wesentlichen die gleiche Lampenleistung aufweisen.

12. Vorrichtung (1) nach einem der vorhergehenden Ansprüche, **dadurch gekennzeichnet, daß** die Heizvorrichtung (12; 14) von einer, wenigstens abschnittsweise die elektromagnetische Strahlung reflektierenden Kammer (4) umgeben ist.

13. Vorrichtung (1) nach Anspruch 12, **dadurch gekennzeichnet, daß** der spektrale Reflexionskoeffizient der Kammer (4) positionsabhängig ist.

14. Vorrichtung (1) nach einem der vorhergehenden Ansprüche, **dadurch gekennzeichnet, daß** die Abstrahlcharakteristika der elektromagnetischen Strahlung der Heizvorrichtung (12; 14) modulierbar sind.

15. Vorrichtung (1) nach einem der vorhergehenden Ansprüche, **dadurch gekennzeichnet, daß** sich die Heizvorrichtung (12; 14) und/oder das Substrat (2) in einem nahezu homogenen, einstellbaren Magnetfeld befindet, dessen Feldlinien wenigstens in der Nähe der Bogenlampenanode eine Komponente aufweisen, die im wesentlichen parallel zu der Bogenentladung der Bogenlampen (15) verläuft.

16. Vorrichtung (1) nach Anspruch 15, **dadurch gekennzeichnet, daß** die magnetische Flußdichte des Magnetfelds zwischen 0.005 und 0.3 Tesla liegt.

17. Vorrichtung (1) nach einem der vorhergehenden Ansprüche, **gekennzeichnet durch** eine zweite Heizvorrichtung (12; 14), wobei das Substrat (2) zwischen den Heizvorrichtungen (12; 14) angeordnet ist.

18. Vorrichtung (1) nach einem der vorhergehenden Ansprüche, **gekennzeichnet durch** eine das Substrat (2) im wesentlichen umgebende, für die elektromagnetische Strahlung der Heizvorrichtung (12, 14) nahezu transparente Reaktionskammer (20).

19. Vorrichtung (1) nach Anspruch 18, **dadurch gekennzeichnet, daß** die Reaktionskammer (20) Quarzglas und/oder Saphir aufweist.

20. Vorrichtung (1) nach einem der Ansprüche 18 oder 19, **dadurch gekennzeichnet, daß** das Reaktionskammermaterial einen über das Spektrum der elektromagnetischen Strahlung gemittelten Absorptionskoeffizienten zwischen 0.001 pro cm und 0.1 pro cm aufweist.

21. Vorrichtung (1) nach einem der Ansprüche 18 bis 20, **dadurch gekennzeichnet, daß** die Reaktionskammer (20) eine Wanddicke zwischen I mm und 5 cm aufweist.

22. Vorrichtung (1) nach einem der vorhergehenden Ansprüche, **dadurch gekennzeichnet, daß** die Glühlampen (16) wenigstens teilweise eine gewendelte Filamentstruktur aufweisen.

23. Vorrichtung (1) nach einem der vorhergehenden Ansprüche, **dadurch gekennzeichnet, daß** durch die Filamentstruktur der Glühlampen (16) ein vordefiniertes geometrisches und spektrales Abstrahlprofil erzielbar ist.

24. Vorrichtung (1) nach einem der vorhergehenden Ansprüche, **dadurch gekennzeichnet, daß** das Filament der Glühlampe (16) abwechselnd gewendelte und ungewendelte Filamentstrukturen aufweist.

25. Vorrichtung (1) nach einem der vorhergehenden Ansprüche, **dadurch gekennzeichnet, daß** wenigstens eine Glühlampe (16) wenigstens zwei einzeln ansteuerbare Filamente aufweist.

26. Vorrichtung (1) nach einem der vorhergehenden Ansprüche, **dadurch gekennzeichnet, daß** wenigstens ein Filament einer Glühlampe (16) wenigstens drei elektrische Anschlüsse aufweist.

27. Vorrichtung (1) nach einem der vorhergehenden Ansprüche, **dadurch gekennzeichnet, daß** die Dichte wenigstens einer Filamentstruktur entlang des Filaments variiert.

28. Vorrichtung (1) nach einem der vorhergehenden Ansprüche, **dadurch gekennzeichnet, daß** die Glühlampen (16) Halogenlampen sind.

29. Vorrichtung (1) nach einem der vorhergehenden Ansprüche, **dadurch gekennzeichnet, daß** die Reaktionskammer (20) und/oder die Lampenkörper einen Frequenzfilter für wenigstens einen Wellenlängenbereich der elektromagnetischen Strahlung der Heizvorrichtung (12, 14) bilden.

30. Vorrichtung (1) nach einem der vorhergehenden Ansprüche, **dadurch gekennzeichnet, daß** wenigstens eine der Lampen (15, 16) zumindest teilweise mit einem Stoff gefüllt ist, der einen bestimmten Wellenlängenbereich der elektromagnetischen Strahlung der Heizvorrichtung (12; 14) absorbiert.

31. Vorrichtung (1) nach einem der vorhergehenden Ansprüche, **dadurch gekennzeichnet, daß** der Stoff im Absorbtionsbereich im wesentlichen nicht emittiert.

32. Verfahren zum thermischen Behandeln von Substraten (2), insbesondere Halbleiterwafern, mit einer Reaktionskammer mit wenigstens einer Heizvorrichtung (12; 14) zum Erwärmen wenigstens eines Substrats (2) durch elektromagnetische Strahlung, wobei die Heizvorrichtung (12; 14) wenigstens zwei Bogenlampen (15) und Glühlampen (16) umfaßt,
**dadurch gekennzeichnet, daß** die Abstrahlcharakteristika für jede Bogenlampe individuell gesteuert werden, die elektromagnetischen Strahlung der Bogenlampen (15) derart gesteuert wird, dass sie wenigstens 1/10 zur Leistungsdichte der elektromagnetischen Strahlung der Heizvorrichtung (12, 14) beiträgt, und der Abstand der Heizvorrichtung (12; 14) zu einer Oberfläche des Substrats (2) kleiner eingestellt wird als der Durchmessers einer Reaktionskammer (22), wobei das Verhältnis zwischen Abstand und Durchmesser kleiner als 0.5 ist.

33. Verfahren nach Anspruch 32, **dadurch gekennzeichnet, daß** der Betriebsmodus und/oder der Lampenstrom der Bogenlampen (15) individuell gesteuert wird.

34. Verfahren nach einem der Ansprüche 32 oder 33, **dadurch gekennzeichnet, daß** die Bogenlampen (15) im Gleichstrombetrieb angesteuert werden.

35. Verfahren nach einem der Ansprüche 32 bis 34, **dadurch gekennzeichnet, daß** die Bogenlampen (15) gepulst im Blitzbetrieb angesteuert werden.

36. Verfahren nach einem der Ansprüche 32 bis 35, **dadurch gekennzeichnet, daß** das Substrat (2) hauptsächlich über Glühlampen (16) erwärmt wird.

37. Verfahren nach einem der Ansprüche 32 bis 36, **dadurch gekennzeichnet, daß** das Substrat (2) in einem unteren Temperaturbereich hauptsächlich über die Bogenlampen (15) erwärmt wird.

38. Verfahren nach einem der Ansprüche 32 bis 37, **dadurch gekennzeichnet, daß** das Substrat (2) in einem unteren Temperaturbereich ausschließlich über die Bogenlampen (15) erwärmt wird.

39. Verfahren nach einem der Ansprüche 37 oder 38, **dadurch gekennzeichnet, daß** der untere Temperaturbereich zwischen Raumtemperatur und ungefähr 600°C liegt.

40. Verfahren nach einem der Ansprüche 32 bis 39, **dadurch gekennzeichnet, daß** die elektromagnetische Strahlung der Heizvorrichtung (12; 14) moduliert wird.

41. Verfahren nach einem der Ansprüche 32 bis 40, **gekennzeichnet durch**, Anlegen eines Magnetfeldes im Bereich des Substrats (2) und/oder der Heizvorrichtung (12; 14), dessen Feldlinien wenigstens im Bereich der Bogenlampenanode eine Komponente aufweisen, die im Wesentlichen parallel zur Bogenentladung verläuft.

## Claims

1. Device (1) for thermal treatment of substrates (2), particularly semiconductor wafers, comprising a reaction chamber with at least one heating device (12; 14) for heating at least one substrate (2) by electromagnetic radiation, wherein the heating device (12; 14) comprises at least two arc lamps (15) as well as incandescent lamps (16), **characterised in that** the radiation characteristics for each arc lamp (15) are individually controllable by a control device, the electromagnetic radiation of the arc lamps (15) contributes substantially to the power density of the electromagnetic radiation of the heating device (12; 14), wherein the arc lamps (15) contribute at least 1/10 to the power density of the heating device, and the spacing of the heating device (12; 14) from a surface of the substrate (2) is smaller than the diameter of the reaction chamber (22), wherein the ratio between spacing and diameter is smaller than 0.5.

2. Device (1) according to claim 1, **characterised in that** the operating mode and/or the lamp current is or are individually controllable.

3. Device (1) according to claim 1 or 2, **characterised in that** the arc lamps (15) are controllable in direct current operation.

4. Device (1) according to one of claims 1 to 3, **characterised in that** the arc lamps (15) are controllable in pulsed manner as flashlamps.

5. Device (1) according to one of the preceding claims, **characterised in that** the arc lamps (15) are fluid-cooled.

6. Device (1) according to one of the preceding claims, **characterised in that** the gas discharge path of the arc lamps (15) substantially corresponds with a dimension of the substrate (2).

7. Device (1) according to one of the preceding claims, **characterised in that** the gas discharge path of the arc lamps (15) is longer than a dimension of the substrate (2).

8. Device (1) according to one of the preceding claims, **characterised in that** the arc lamps (15) are arranged in the region of the outer circumference of the substrate (2).

9. Device (1) according to one of the preceding claims, **characterised in that** the heating device comprises a bank of lamps with at least two rod-shaped lamps (15; 16) arranged almost parallel to one another.

10. Device (1) according to one of the preceding claims, **characterised in that** the incandescent lamps (16) and the arc lamps (15) have substantially the same dimensions.

11. Device (1) according to one of the preceding claims, **characterised in that** the incandescent lamps (16) and the arc lamps (15) have substantially the same lamp power.

12. Device (1) according to one of the preceding claims, **characterised in that** the heating device (12; 14) is surrounded by a chamber (4) reflecting the electromagnetic radiation at least in sections.

13. Device (1) according to claim 12, **characterised in that** the spectral coefficient of reflection of the chamber (5) is dependent on position.

14. Device (1) according to one of the preceding claims, **characterised in that** the radiation characteristics of the electromagnetic radiation of the heating device (12; 14) can be modulated.

15. Device (1) according to one of the preceding claims, **characterised in that** the heating device (12; 14) and/or the substrate (2) is or are disposed in an almost homogenous, adjustable magnetic field, the field lines of which have at least in the vicinity of the arc lamp anode a component extending substantially parallel to the arc discharge of the arc lamps (15).

16. Device (1) according to claim 15, **characterised in that** the magnetic flux density of the magnetic field lies between 0.005 and 0.3 Tesla.

17. Device (1) according to one of the preceding claims, **characterised by** a second heating device (12; 14), wherein the substrate (2) is arranged between the heating devices (12; 14).

18. Device (1) according to one of the preceding claims, **characterised by** a reaction chamber (20) which substantially surrounds the substrate (2) and is almost transparent to the electromagnetic radiation of the heating device (12; 14).

19. Device (1) according to claim 18, **characterised in that** the reaction chamber (20) comprises quartz glass and/or sapphire.

20. Device (1) according to one of claims 18 and 19, **characterised in that** the reaction chamber material has an absorption coefficient between 0.001 per centimetre and 0.1 per centimetre averaged over the spectrum of the electromagnetic radiation.

21. Device (1) according to one of claims 18 to 20, **characterised in that** the reaction chamber (20) has a wall thickness between 1 millimetre and 5 centimetres.

22. Device (1) according to one of the preceding claims, **characterised in that** the incandescent lamps (16) have at least in part a coiled filament structure.

23. Device (1) according to one of the preceding claims, **characterised in that** a predefined geometric and spectral radiation profile is achievable by the filament structure of the incandescent lamps (16).

24. Device (1) according to one of the preceding claims, **characterised in that** the filament of the incandescent lamp (16) has coiled and non-coiled filament structures in alternation.

25. Device (1) according to one of the preceding claims, **characterised in that** at least one incandescent lamp (16) comprises at least two individually controllable filaments.

26. Device (1) according to one of the preceding claims, **characterised in that** at least one filament of an incandescent lamp (16) has at least three electrical terminals.

27. Device (1) according to one of the preceding claims, **characterised in that** the density of at least one filament structure varies along the filament.

28. Device (1) according to one of the preceding claims, **characterised in that** the incandescent lamps (16) are halogen lamps.

29. Device (1) according to one of the preceding claims, **characterised in that** the reaction chamber (20) and/or the lamp body forms or form a frequency filter for at least one wavelength range of the electromagnetic radiation of the heating device (12, 14).

30. Device (1) according to one of the preceding claims, **characterised in that** at least one of the lamps (15, 16) is filled at least partly with a substance which absorbs a specific wavelength range of the electromagnetic radiation of the heating device (12; 14).

31. Device (1) according to one of the preceding claims, **characterised in that** the substance is substantially non-emitting in the absorption range.

32. Method for thermal treatment of substrates (2), particularly semiconductor wafers, comprising a reaction chamber with at least one heating device (12; 14) for heating at least one substrate (2) by electromagnetic radiation, wherein the heating device (12; 14) comprises at least two arc lamps (15) as well as incandescent lamps (16), **characterised in that** the radiation characteristics for each arc lamp are individually controlled, the electromagnetic radiation of the arc lamps (15) is controlled in such a manner that they contribute at least 1/10 to the power density of the electromagnetic radiation of the heating device (12, 14) and the spacing of the heating device (12; 14) from a surface of the substrate (2) is set to be smaller than the diameter of a reaction chamber (22), wherein the ratio between spacing and diameter is smaller than 0.5.

33. Method according to claim 32, **characterised in that** the operating mode and/or the lamp current of the arc lamps (15) is or are individually controlled.

34. Method according to one of claims 32 and 33, **characterised in that** the arc lamps (15) are controlled in direct current operation.

35. Method according to one of claims 32 to 34, **characterised in that** the arc lamps (15) are controlled in pulsed manner in flash operation.

36. Method according to one of claims 32 to 35, **characterised in that** the substrate (2) is heated principally by way of incandescent lamps (16).

37. Method according to one of claims 32 to 36, **characterised in that** the substrate (2) is heated in a lower temperature range principally by way of the arc lamps (15).

38. Method according to one of claims 32 to 37, **characterised in that** the substrate (2) is heated in a lower temperature range exclusively by way of the arc lamps (15).

39. Method according to one of claims 37 and 38, **characterised in that** the lower temperature range lies between room temperature and approximately 600° C.

40. Method according to one of claims 32 to 39, **characterised in that** the electromagnetic radiation of the heating device (12; 14) is modulated.

41. Method according to one of claims 32 to 40, **characterised by** application of a magnetic field in the region of the substrate (2) and/or the heating device (12; 14), the field lines of which at least in the region of the arc lamp anode have a component extending substantially parallel to the arc discharge.

## Revendications

1. Dispositif (1) pour le traitement thermique de substrats (2), en particulier de tranches pour semiconducteurs, comprenant une chambre de réaction, au moins un dispositif de chauffage (12; 14) pour le réchauffement d'au moins un substrat (2) par rayonnement électromagnétique, le dispositif de chauffage (12; 14) comprenant au moins deux lampes à arc (15) et des lampes à incandescence (16),
**caractérisé en ce que** les caractéristiques de rayonnement peuvent être contrôlées individuellement pour chaque lampe à arc (15) par un dispositif de commande, le rayonnement électromagnétique des lampes à arc (15) contribuant de façon importante à la densité de puissance du rayonnement électromagnétique du dispositif de chauffage (12; 14), les lampes à arc (15) contribuant pour au moins 1/10 à la densité de puissance du dispositif de chauffage, et la distance du dispositif de chauffage (12; 14) à une surface du substrat (2) étant inférieure au diamètre de la chambre de réaction (22), le rapport entre la distance et le diamètre étant inférieur à 0,5.

2. Dispositif (1) selon la revendication 1, **caractérisé en ce que** le mode de service et/ou le flux de lampe peut être commandé individuellement.

3. Dispositif (1) selon la revendication 1 ou 2, **caractérisé en ce que** les lampes à arc (15) peuvent être amorcées en mode de courant continu.

4. Dispositif (1) selon l'une quelconque des revendications 1 à 3, **caractérisé en ce que** les lampes à arc (15) peuvent être amorcées de façon pulsée comme lampes flash.

5. Dispositif (1) selon l'une quelconque des revendications précédentes, **caractérisé en ce que** les lampes à arc (15) sont refroidies par fluide.

6. Dispositif (1) selon l'une quelconque des revendications précédentes, **caractérisé en ce que** le tronçon de décharge de gaz des lampes à arc (15) correspond sensiblement à une dimension du substrat (2).

7. Dispositif (1) selon l'une quelconque des revendications précédentes, **caractérisé en ce que** le tronçon de décharge de gaz des lampes à arc (15) est plus long qu'une dimension du substrat (2).

8. Dispositif (1) selon l'une quelconque des revendications précédentes, **caractérisé en ce que** les lampes à arc (15) sont disposées dans la zone du pourtour extérieur du substrat (2).

9. Dispositif (1) selon l'une quelconque des revendications précédentes, **caractérisé en ce que** le dispositif de chauffage présente un banc de lampes avec au moins deux lampes (15; 16) en forme de barre et disposées pratiquement parallèlement entre elles.

10. Dispositif (1) selon l'une quelconque des revendications précédentes, **caractérisé en ce que** les lampes à incandescence (16) et les lampes à arc (15) présentent sensiblement les mêmes dimensions.

11. Dispositif (1) selon l'une quelconque des revendications précédentes, **caractérisé en ce que** les lampes à incandescence (16) et les lampes à arc (15) présentent sensiblement la même puissance de lampe.

12. Dispositif (1) selon l'une quelconque des revendications précédentes, **caractérisé en ce que** le dispositif de chauffage (12; 14) est entouré par une chambre réfléchissant au moins par endroits le rayonnement électromagnétique.

13. Dispositif (1) selon la revendication 12, **caractérisé en ce que** le coefficient de réflexion spectral de la chambre (4) est dépendant de la position.

14. Dispositif (1) selon l'une quelconque des revendications précédentes, **caractérisé en ce que** les caractéristiques de rayonnement du rayonnement électromagnétique du dispositif de chauffage (12; 14) peuvent être modulées.

15. Dispositif (1) selon l'une quelconque des revendications précédentes, **caractérisé en ce que** le dispositif de chauffage (12; 14) et/ou le substrat (2) se trouve(nt) dans un champ magnétique réglable et pratiquement homogène, dont les lignes de champ présentent au moins à proximité de l'anode de la lampe à arc une composante qui est agencée sensiblement parallèlement à la décharge des lampes à arc (15).

16. Dispositif (1) selon la revendication 15, **caractérisé en ce que** la densité de flux magnétique du champ magnétique se situe entre 0,005 et 0,3 Tesla.

17. Dispositif (1) selon l'une quelconque des revendications précédentes, **caractérisé par** un second dispositif de chauffage (12; 14), le substrat (2) étant disposé entre les dispositifs de chauffage (12; 14).

18. Dispositif (1) selon l'une quelconque des revendications précédentes, **caractérisé par** une chambre de réaction (20) entourant sensiblement le substrat (2) et pratiquement transparente pour le rayonnement électromagnétique du dispositif de chauffage (12, 14).

19. Dispositif (1) selon la revendication 18, **caractérisé en ce que** la chambre de réaction (20) présente du verre de quartz et/ou du saphir.

20. Dispositif (1) selon l'une quelconque des revendications 18 ou 19, **caractérisé en ce que** le matériau de la chambre de réaction présente un coefficient d'absorption calculé en moyenne sur le spectre du rayonnement électromagnétique compris entre 0,001 par cm et 0,1 par cm.

21. Dispositif (1) selon l'une quelconque des revendications 18 à 20, **caractérisé en ce que** la chambre de réaction (20) présente une épaisseur de paroi comprise entre 1 mm et 5 cm.

22. Dispositif (1) selon l'une quelconque des revendications précédentes, **caractérisé en ce que** les ampoules à incandescence (16) présentent au moins partiellement une structure de filament spiralée.

23. Dispositif (1) selon l'une quelconque des revendications précédentes, **caractérisé en ce que** qu'un profil de rayonnement géométrique et spectral prédéfini peut être obtenu par la structure de filament des lampes à incandescence (16).

24. Dispositif (1) selon l'une quelconque des revendications précédentes, **caractérisé en ce que** le filament de la lampe à incandescence (16) présente des structures de filament alternativement spiralées et non spiralées.

25. Dispositif (1) selon l'une quelconque des revendications précédentes, **caractérisé en ce qu'**au moins une lampe à incandescence (16) présente au moins deux filaments pouvant être commandés individuellement.

26. Dispositif (1) selon l'une quelconque des revendications précédentes, **caractérisé en ce qu'**au moins un filament d'une lampe à incandescence (16) présente trois branchements électriques.

27. Dispositif (1) selon l'une quelconque des revendications précédentes, **caractérisé en ce que** la densité d'au moins une structure de filament varie le long du filament.

28. Dispositif (1) selon l'une quelconque des revendications précédentes, **caractérisé en ce que** les lampes à incandescence (16) sont des lampes halogène.

29. Dispositif (1) selon l'une quelconque des revendications précédentes, **caractérisé en ce que** la chambre de réaction (20) et/ou les corps de lampe forment un filtre de fréquence pour au moins une plage de longueurs d'onde du rayonnement électromagnétique du dispositif de chauffage (12, 14).

30. Dispositif (1) selon l'une quelconque des revendications précédentes, **caractérisé en ce qu'**au moins une des lampes (15, 16) est remplie au moins partiellement avec une substance qui absorbe une plage définie de longueurs d'onde du rayonnement électromagnétique du dispositif de chauffage (12; 14).

31. Dispositif (1) selon l'une quelconque des revendications précédentes, **caractérisé en ce que** la substance n'émet sensiblement pas dans la plage d'absorption.

32. Procédé pour le traitement thermique de substrats (2), en particulier de tranches pour semiconducteurs, comprenant une chambre de réaction (22) avec au moins un dispositif de chauffage (12; 14) pour le réchauffement d'au moins un substrat (2) par rayonnement électromagnétique, le dispositif de chauffage (12; 14) comprenant au moins deux lampes à arc (15) et lampes à incandescence (16),
**caractérisé en ce que** les caractéristiques de rayonnement peuvent être commandées individuellement pour chaque lampe à arc, le rayonnement électromagnétique des lampes à arc (15) est commandé de telle sorte qu'il contribue au moins pour 1/10 à la densité de puissance du rayonnement électromagnétique du dispositif de chauffage (12, 14) et la distance du dispositif de chauffage (12; 14) à une surface du substrat (2) est réglée plus petite que le diamètre d'une chambre de réaction (22), le rapport entre la distance et le diamètre étant inférieur à 0,5.

33. Procédé selon la revendication 32, **caractérisé en ce que** le mode de service et/ou le flux de lampe des lampes à arc (15) est commandé individuellement.

34. Procédé selon l'une quelconque des revendications 32 ou 33, **caractérisé en ce que** les lampes à arc (15) sont commandées en mode de courant continu.

35. Procédé selon l'une quelconque des revendications 30 à 34, **caractérisé en ce que** les lampes à arc (15) sont commandées de façon pulsée en mode flash.

36. Procédé selon l'une quelconque des revendications 32 à 35, **caractérisé en ce que** le substrat (2) est réchauffé principalement par des lampes à incandescence (16).

37. Procédé selon l'une quelconque des revendications 32 à 36, **caractérisé en ce que** le substrat (2) est réchauffé dans une plage de températures inférieure principalement par les lampes à arc (15).

38. Procédé selon l'une quelconque des revendications 32 à 37, **caractérisé en ce que** le substrat (2) est réchauffé dans une plage de températures inférieure exclusivement par les lampes à arc (15).

39. Procédé selon l'une quelconque des revendications 37 ou 38, **caractérisé en ce que** la plage de températures inférieure est située entre la température ambiante et environ 600°C.

40. Procédé selon l'une quelconque des revendications 32 à 39, **caractérisé en ce que** le rayonnement électromagnétique du dispositif de chauffage (12; 14) est modulé.

41. Procédé selon l'une quelconque des revendications 32 à 40, **caractérisé par** l'application d'un champ magnétique dans la zone du substrat (2) et/ou du dispositif de chauffage (12; 14), dont les lignes de champ présentent au moins dans la zone de l'anode de la lampe à arc une composante qui est agencée sensiblement parallèlement à la décharge de l'arc.
